(19)

Europäisches Patentamt

European Patent Office

Office européen des brevets

(11) **EP 2 432 020 A1**

(12) **EUROPEAN PATENT APPLICATION**
published in accordance with Art. 153(4) EPC

(43) Date of publication:
**21.03.2012 Bulletin 2012/12**

(21) Application number: **10774830.3**

(22) Date of filing: **27.04.2010**

(51) Int Cl.:
*H01L 29/12* (2006.01)  *H01L 21/02* (2006.01)
*H01L 21/20* (2006.01)  *H01L 21/336* (2006.01)
*H01L 29/78* (2006.01)

(86) International application number:
**PCT/JP2010/057444**

(87) International publication number:
**WO 2010/131572 (18.11.2010 Gazette 2010/46)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **11.05.2009   JP 2009114737**
**24.09.2009   JP 2009219065**
**01.10.2009   JP 2009229764**
**29.10.2009   JP 2009248621**

(71) Applicant: **Sumitomo Electric Industries, Ltd.**
**Osaka 541 0041 (JP)**

(72) Inventors:
 • **WADA, Keiji**
  **Osaka-shi**
  **Osaka 554-0024 (JP)**
 • **HARADA, Shin**
  **Osaka-shi**
  **Osaka 554-0024 (JP)**
 • **MASUDA, Takeyoshi**
  **Osaka-shi**
  **Osaka 554-0024 (JP)**

 • **HONAGA, Misako**
  **Osaka-shi**
  **Osaka 554-0024 (JP)**
 • **SASAKI, Makoto**
  **Itami-shi**
  **Hyogo 664-0016 (JP)**
 • **NISHIGUCHI, Taro**
  **Itami-shi**
  **Hyogo 664-0016 (JP)**
 • **NAMIKAWA, Yasuo**
  **Osaka-shi**
  **Osaka 554-0024 (JP)**
 • **FUJIWARA, Shinsuke**
  **Itami-shi**
  **Hyogo 664-0016 (JP)**

(74) Representative: **Grünecker, Kinkeldey,**
**Stockmair & Schwanhäusser**
**Anwaltssozietät**
**Leopoldstrasse 4**
**80802 München (DE)**

(54) **SEMICONDUCTOR DEVICE**

(57)     A MOSFET (100), which is a semiconductor device allowing for reduced on-resistance while restraining stacking faults from being produced due to heat treatment in a device manufacturing process, includes: a silicon carbide substrate (1); an active layer (7) made of single-crystal silicon carbide and disposed on one main surface of the silicon carbide substrate (1); a source contact electrode (92) disposed on the active layer (7); and a drain electrode (96) formed on the other main surface of the silicon carbide substrate (1). The silicon carbide substrate (1) includes: a base layer (10) made of silicon carbide; and a SiC layer (20) made of single-crystal silicon carbide and disposed on the base layer (10). Further, the base layer (10) has an impurity concentration greater than $2 \times 10^{19} \text{ cm}^{13}$, and the SiC layer (20) has an impurity concentration greater than $5 \times 10^{18} \text{ cm}^{13}$ and smaller than $2 \times 10^{19} \text{ cm}^{-3}$.

FIG.1

**Description**

TECHNICAL FIELD

The present invention relates to a semiconductor device, more particularly, a semiconductor device allowing for reduced on-resistance while restraining stacking faults from being produced due to heat treatment in a device manufacturing process.

BACKGROUND ART

In recent years, in order to achieve high breakdown voltage, low loss, and utilization of semiconductor devices under a high temperature environment, silicon carbide (SiC) has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

In order to manufacture the high-performance semiconductor device adopting silicon carbide as its material, it is effective to employ a process of preparing a substrate made of silicon carbide (silicon carbide substrate), and forming an epitaxial growth layer made of SiC on the silicon carbide substrate. Further, on-resistance of the device can be reduced by reducing resistivity of the substrate in the thickness direction thereof as much as possible when manufacturing, for example, a vertical type power device (such as a vertical type MOSFET (Metal Oxide Semiconductor Field Effect Transistor) using the silicon carbide substrate. Further, in order to reduce the resistivity of the substrate in the thickness direction thereof, for example, there can be employed a method of introducing an impurity, which is an n type dopant such as nitrogen, into the substrate at a high concentration (for example, see R. C. GLASS et al., "SiC Seeded Crystal Growth", Phys. stat. sol. (b), 1997, 202, p149-162 (Non-Patent Literature 1)).

CITATION LIST

NON PATENT LITERATURE

NPL 1: R. C. GLASS et al., "SiC Seeded Crystal Growth", Phys. stat. sol. (b), 1997, 202, p149-162

SUMMARY OF INVENTION

TECHNICAL PROBLEM

However, if the resistivity of the substrate is reduced by simply introducing the impurity into the substrate at a high concentration, the following problem takes place. That is, when fabricating a semiconductor device using the silicon carbide substrate, the silicon carbide substrate is subjected to heat treatment such as thermal cleaning for cleaning a surface of the silicon carbide substrate. On this occasion, stacking faults are produced in the silicon carbide substrate containing the impurity at a high concentration. When an epitaxial growth layer made of SiC is formed on the silicon carbide substrate, the stacking faults are propagated to the SiC layer. Here, assuming that the SiC constituting the silicon carbide substrate is for example 4H-SiC, each of the stacking faults to be produced has a structure of 3C type, which has a band gap smaller than that in the 4H type. Accordingly, the band gap becomes smaller locally in the region in which the stacking faults are produced. As a result, if a semiconductor device is fabricated using such a silicon carbide substrate, problems will take place such as reduced breakdown voltage and increased leakage current.

In view of these, the present invention has its object to provide a semiconductor device allowing for reduced on-resistance while restraining stacking faults from being produced due to heat treatment in a device manufacturing process.

SOLUTION TO PROBLEM

A semiconductor device according to the present invention includes: a silicon carbide substrate; an active layer made of single-crystal silicon carbide and disposed on one main surface of the silicon carbide substrate; a first electrode disposed on the active layer; and a second electrode formed on the other main surface of the silicon carbide substrate. The silicon carbide substrate includes a base layer made of silicon carbide, and a SiC layer made of single-crystal silicon carbide and disposed on the base layer. The base layer has an impurity concentration greater than $2 \times 10^{19}$ cm$^{-3}$ and the SiC layer has an impurity concentration greater than $5 \times 10^{18}$ cm$^{-3}$ and smaller than $2 \times 10^{19}$ cm$^{-3}$.

The present inventors have fully studied approaches for reducing resistivity of a silicon carbide substrate in the thickness direction thereof while restraining stacking faults from being produced due to heat treatment in a device manufacturing process. As a result, it has been found that the stacking faults can be prevented from being produced due to the heat treatment when the impurity concentration thereof is less than $2 \times 10^{19}$ cm$^{-3}$, whereas the stacking faults are less likely to be prevented when the impurity concentration exceeds $2 \times 10^{19}$ cm$^{-3}$. In view of this, the silicon carbide substrate is provided with the layer (base layer) having an impurity concentration greater than $2 \times 10^{19}$ cm$^{-3}$ and having a small resistivity and the layer (SiC layer) having an impurity concentration smaller than $2 \times 10^{19}$ cm$^{-3}$ and placed on the base layer. Accordingly, even if heat treatment is subsequently performed in the device manufacturing process, stacking faults can be prevented from being produced at least in the SiC layer. Further, by forming an epitaxial growth layer (active layer) made of SiC on such a SiC layer so as to fabricate the semiconductor device, the resistivity of the silicon carbide substrate can be reduced by the existence of the base layer, while preventing influence of stacking faults, which can be produced in the base layer, over the characteristics of the semiconductor device. Meanwhile, when the impurity concentration of the SiC layer is equal to or smaller than $5 \times 10^{18}$ cm$^{-3}$, the resistivity of the SiC layer can become too large, disadvantageously.

Thus, according to the semiconductor device of the present invention, there can be provided a semiconductor device allowing for reduced on-resistance while restraining stacking fault from being produced due to heat treatment in the device manufacturing process. Here, the term "impurity" refers to an impurity to be introduced to produce a majority carrier in the silicon carbide substrate.

Further, the base layer and the SiC layer are connected to each other, for example. In this way, the silicon carbide substrate can be readily obtained in which the SiC layer is provided while preventing propagation of the defects of the base layer. On this occasion, the base layer and the SiC layer may be directly connected to each other, or may be connected to each other via an intermediate layer.

In the semiconductor device, the impurity contained in the base layer may be different from that contained in the SiC layer. In this way, a semiconductor device can be obtained which includes the silicon carbide substrate containing impurities appropriately depending on intended purpose of use.

In the semiconductor device, the impurity contained in the base layer can be nitrogen or phosphorus, whereas the impurity contained in the SiC layer can be also nitrogen or phosphorus. Each of nitrogen and phosphorus is suitable as an impurity for supplying the SiC with electrons, which serve as majority carriers.

In the semiconductor device, the base layer may be made of single-crystal silicon carbide and a half width of X-ray rocking curve of the SiC layer may be smaller than that of the base layer.

SiC does not have a liquid phase at an atmospheric pressure. Hence, in a sublimation recrystallizing method, which is generally used to fabricate a bulk single-crystal SiC by growing it in the <0001> direction of the hexagonal crystal, the crystal growth temperature is very high, specifically, equal to or greater than 2000°C, which makes it difficult to control and stabilize the growth conditions. Accordingly, it is difficult for a substrate made of single-crystal SiC to keep its high quality and have a large diameter. Meanwhile, for efficient manufacturing in a process of manufacturing a semiconductor device using a silicon carbide substrate, a substrate provided with predetermined uniform shape and size is required. Hence, even when a high-quality silicon carbide single-crystal (for example, single-crystal silicon carbide having a low dislocation density or having small misalignment of crystal axes and a small half width of X-ray rocking curve) is obtained, a region that cannot be processed into such a predetermined shape and the like by cutting, etc., may not be effectively used.

To address this, in the silicon carbide substrate of the present invention, on the base layer processed into the predetermined shape and size, there can be disposed the SiC layer having, for example, a smaller half width of the X-ray rocking curve, i.e., having higher crystallinity than that of the base layer but not formed into the desired shape and the like. Such a silicon carbide substrate has the predetermined uniform shape and size corresponding to those of the base layer, thus attaining effective manufacturing of semiconductor devices. Further, such a silicon carbide substrate utilizes the high-quality SiC layer to manufacture a semiconductor device, thereby effectively utilizing the high-quality single-crystal silicon carbide. As a result, the manufacturing cost of the semiconductor device can be reduced.

In the semiconductor device, the active layer may include: a drift layer having a first conductivity type, disposed on/over the silicon carbide substrate, and made of single-crystal silicon carbide; a well region having a second conductivity type and disposed to include a first main surface of the drift layer opposite to the silicon carbide substrate; a source region having the first conductivity type and disposed in contact with the first electrode to include the first main surface within the well region; an insulating film disposed on the first main surface in contact with the well region and made of an insulator; and a third electrode disposed on the insulating film.

Accordingly, there can be obtained a MISFET (Metal Insulator Semiconductor Field Effect Transistor) employing the first electrode as a source electrode, the drain electrode as a second electrode, and the third electrode as a gate electrode.

In the semiconductor device, the insulating film may be made of silicon dioxide. In this way, a MOSFET (Metal Oxide Semiconductor Field Effect Transistor) can be obtained.

In the silicon carbide substrate of the semiconductor device, the main surface of the SiC layer opposite to the base layer may have an off angle of not less than 50° and not more than 65° relative to a {0001} plane.

By growing single-crystal silicon carbide of hexagonal system in the <0001> direction, a high-quality single-crystal can be fabricated efficiently. From such a silicon carbide single-crystal grown in the <0001> direction, a silicon carbide substrate having a main surface corresponding to the {0001} plane can be obtained efficiently. Meanwhile, by using a silicon carbide substrate having a main surface having an off angle of not less than 50° and not more than 65° relative to the plane orientation of {0001}, a semiconductor device with high performance may be manufactured.

Specifically, for example, generally a silicon carbide substrate used for fabrication of a MOSFET has a main surface having an off angle of approximately 0.3° to 8° relative to a plane orientation of {0001}. An epitaxial growth layer (active layer) is formed on this main surface and an insulating film (oxide film), an electrode, and the like are formed on this active layer, thereby obtaining a MOSFET. In this MOSFET, a channel region is formed in a region including an interface between the active layer and the insulating film. However, in the MOSFET having such a structure, a multiplicity of interface states are formed around the interface between the active layer and the insulating film, i.e., the location in which the channel region is formed, due to the substrate's main surface having an off angle of approximately 0.3°-8° relative to the {0001} plane. Accordingly, channel mobility is decreased by carriers trapped therein or scattering caused by the trapped carriers.

To address this, in the silicon carbide substrate, the main surface of the SiC layer opposite to the base layer is adapted to have an off angle of not less than 50° and not more than 65° relative to the {0001} plane, thereby reducing formation of the interface states. In this way, a MOSFET can be fabricated which allows for reduced on-resistance.

In the silicon carbide substrate of the semiconductor device, the main surface of the SiC layer opposite to the base layer has an off orientation forming an angle of 5° or smaller relative to a <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer (active layer) to be formed readily on the silicon carbide substrate.

In the silicon carbide substrate, the main surface of the SiC layer opposite to the base layer may have an off angle of not less than -3° and not more than 5° relative to a {03-38} plane in the <1-100> direction. Accordingly, channel mobility can be further improved in the case where a MOSFET is fabricated using the silicon carbide substrate. Here, setting the off angle at not less than -3° and not more than +5° relative to the plane orientation of {03-38} is based on a fact that particularly high channel mobility was obtained in this set range as a result of inspecting a relation between the channel mobility and the off angle.

Further, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

More preferably, the plane orientation of the main surface is substantially {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle of ±2° relative to {03-38}. Accordingly, the above-described channel mobility can be further improved.

In the silicon carbide substrate of the semiconductor device, the main surface of the SiC layer opposite to the base layer may have an off orientation forming an angle of 5° or smaller relative to a <11-20> direction.

<11-20> is a representative off orientation in a silicon carbide substrate, as with the <1-100> direction. Variation in the off orientation resulting from variation in the slicing process of the process of manufacturing the substrate is adapted to be ±5°, which allows an epitaxial growth layer (active layer) to be formed readily on the SiC substrate.

In the semiconductor device, the base layer may be made of single-crystal silicon carbide. In this case, the SiC layer preferably has a defect density smaller than that of the base layer.

For example, in the semiconductor device, the SiC layer preferably has a micro pipe density smaller than that of the base layer.

Further, in the semiconductor device, the SiC layer preferably has a dislocation density lower than that of the base layer.

Further, in the semiconductor device, the SiC layer preferably has a threading screw dislocation density smaller than that of the base layer. Further, in the semiconductor device, the SiC layer preferably has a threading edge dislocation density smaller than that of the base layer. Further, in the semiconductor device, the SiC layer preferably has a basal plane dislocation density smaller than that of the base layer. Further, in the semiconductor device, the SiC layer preferably has a composite dislocation density smaller than that of the base layer. Further, in the semiconductor device, the SiC layer preferably has a stacking fault density smaller than that of the base layer. Further, in the semiconductor device, the SiC layer preferably has a point defect density smaller than that of the base layer.

As compared with the base layer, the SiC layer is adapted to have the reduced defect densities such as the micro pipe density, the threading screw dislocation density, the threading edge dislocation density, the basal plane dislocation density, the composite dislocation density, the stacking fault density, and the point defect density. Such a SiC layer allows a high-quality active layer to be formed on the SiC layer. The active layer can be formed by, for example, combining epitaxial growth and ion implantation of an impurity.

In the semiconductor device, a plurality of the SiC layers may be provided. In this way, there can be obtained a semiconductor device including the plurality of SiC layers corresponding to intended functions.

In the semiconductor device, the silicon carbide substrate may further include an intermediate layer disposed between the base layer and the SiC layer and made of a conductor or a semiconductor, and the intermediate layer connects the base layer and the SiC layer to each other.

By thus employing the structure in which the base layer and the SiC layer are connected to each other by the intermediate layer, there can be readily obtained a semiconductor device including the silicon carbide substrate in which the SiC layer having an impurity concentration greater than $5 \times 10^{18}$ cm$^{-3}$ and smaller than $2 \times 10^{19}$ cm$^{-3}$ is disposed on the base layer having an impurity concentration greater than $2 \times 10^{19}$ cm$^{-3}$. Further, when the intermediate layer is made of a conductor or a semiconductor, electric connection can be secured between the base layer and the SiC layer.

In the semiconductor device, the intermediate layer may be made of a metal. The metal constituting this intermediate layer may have a silicided portion. Further, in the semiconductor device, the intermediate layer may be made of carbon. Further, the intermediate layer may be made of amorphous silicon carbide. Accordingly, electric connection can be readily secured between the base layer and the SiC layer in the thickness direction of the substrate.

In the silicon carbide substrate, the base layer may include a single-crystal layer made of single-crystal silicon carbide and including its main surface facing the SiC layer. Accordingly, a difference in physical property (for example, difference in linear expansion coefficient) becomes small between the base layer and the SiC layer, thereby restraining warpage of the silicon carbide substrate. On this occasion, when influence of the crystallinity of the base layer over the characteristics of the semiconductor device is small, a region other than the single-crystal layer in the base layer may be a non single-crystal layer such as polycrystal silicon carbide, amorphous silicon carbide, or a silicon carbide sintered compact. Accordingly, the manufacturing cost of the semiconductor device can be reduced.

Further, in the silicon carbide substrate, a half width of X-ray rocking curve of the SiC layer is preferably smaller than that of the single-crystal layer. Furthermore, in the silicon carbide substrate, the SiC layer preferably has a micro pipe density smaller than that of the single-crystal layer. Further, in the silicon carbide substrate, the SiC layer preferably has a dislocation density lower than that of the single-crystal layer. This allows a high-quality active layer to be formed on the SiC layer. The active layer can be formed by, for example, combining epitaxial growth and ion implantation of an impurity.

ADVANTAGEOUS EFFECTS OF INVENTION

As apparent from the description above, according to the semiconductor device of the present invention, there can be provided a semiconductor device allowing for reduced on-resistance while restraining stacking fault from being produced due to heat treatment in a device manufacturing process.

BRIEF DESCRIPTION OF DRAWINGS

Fig. 1 is a schematic cross sectional view showing a structure of a MOSFET.
Fig. 2 is a schematic cross sectional view showing a structure of a silicon carbide substrate.
Fig. 3 is a flowchart schematically showing a method for manufacturing the MOSFET.
Fig. 4 is a schematic cross sectional view for illustrating the method for manufacturing the MOSFET.
Fig. 5 is a schematic cross sectional view for illustrating the method for manufacturing the MOSFET.
Fig. 6 is a schematic cross sectional view for illustrating the method for manufacturing the MOSFET.
Fig. 7 is a flowchart schematically showing a method for manufacturing the silicon carbide substrate.
Fig. 8 is a flowchart schematically showing a method for manufacturing a silicon carbide substrate in a second embodiment.
Fig. 9 is a schematic cross sectional view for illustrating the method for manufacturing the silicon carbide substrate in the second embodiment.

Fig. 10 is a schematic cross sectional view for illustrating the method for manufacturing the silicon carbide substrate in the second embodiment.

Fig. 11 is a schematic cross sectional view for illustrating a method for manufacturing a silicon carbide substrate in the second embodiment.

Fig. 12 is a schematic cross sectional view showing a structure of the silicon carbide substrate in a third embodiment.

Fig. 13 is a schematic cross sectional view showing a structure of a silicon carbide substrate in a fourth embodiment.

Fig. 14 is a flowchart schematically showing a method for manufacturing the silicon carbide substrate in the fourth embodiment.

Fig. 15 is a schematic cross sectional view showing a structure of a silicon carbide substrate in a fifth embodiment.

Fig. 16 is a flowchart schematically showing a method for manufacturing the silicon carbide substrate in the fifth embodiment.

Fig. 17 is a schematic cross sectional view showing a structure of a silicon carbide substrate in a sixth embodiment.

Fig. 18 is a flowchart schematically showing a method for manufacturing the silicon carbide substrate in the sixth embodiment.

Fig. 19 is a schematic cross sectional view for illustrating the method for manufacturing the silicon carbide substrate in the sixth embodiment.

Fig. 20 shows a relation between impurity concentration and mobility in n type 4H-SiC.

DESCRIPTION OF EMBODIMENTS

The following describes an embodiment of the present invention with reference to figures. It should be noted that in the below-mentioned figures, the same or corresponding portions are given the same reference characters and are not described repeatedly.

(First Embodiment)

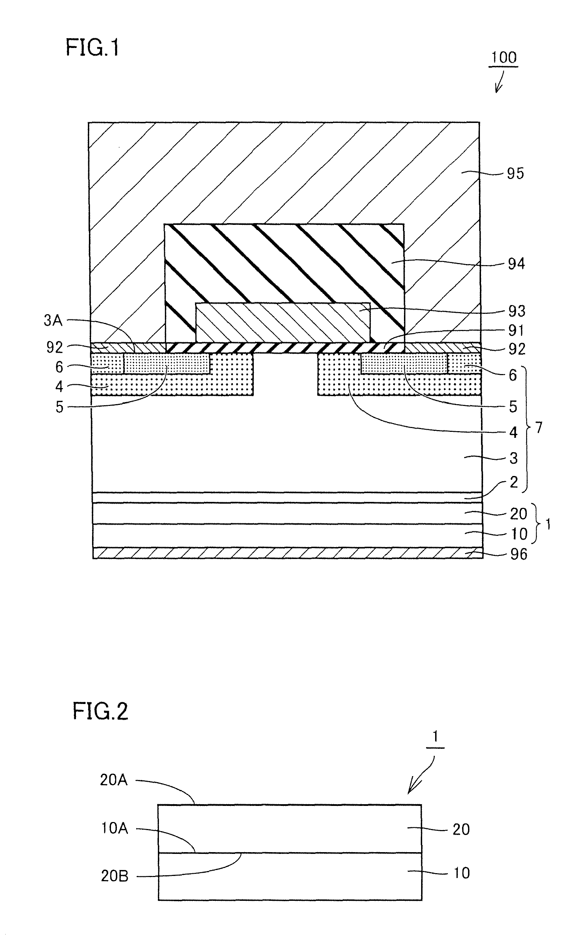

First, a first embodiment, i.e., one embodiment of the present invention, will be described. Referring to Fig. 1, a MOSFET 100, which is a semiconductor device in the present embodiment, includes: a silicon carbide substrate 1 having n type conductivity (first conductivity type); a buffer layer 2 made of silicon carbide and having n type conductivity; a drift layer 3 made of silicon carbide and having n type conductivity; a pair of well regions 4 each having p type conductivity (second conductivity type); $n^+$ regions 5 each serving as a source region having n type conductivity; and $p^+$ regions 6 each serving as a high-concentration second conductivity type region having p type conductivity.

Buffer layer 2 is formed on one main surface of silicon carbide substrate 1, and contains an n type impurity and therefore has n type conductivity. Drift layer 3 is formed on buffer layer 2, and contains an n type impurity and therefore has n type conductivity. The n type impurity contained in drift layer 3 is, for example, N (nitrogen), and is contained therein at a concentration (density) lower than that of the n type impurity contained in buffer layer 2.

The pair of well regions 4 are formed in drift layer 3 to be separated from each other and include a main surface 3A of drift layer 3 opposite to its main surface at the silicon carbide substrate 1 side. Each of well regions 4 contains a p type impurity (impurity having p type conductivity) and therefore has p type conductivity (second conductivity type). The p type impurity contained in well region 4 is, for example, aluminum (Al), boron (B), or the like.

$N^+$ regions 5, which include main surface 3A as described above, are surrounded by well regions 4 and are formed within the pair of well regions 4. Each of $n^+$ regions 5 contains an n type impurity such as P at a concentration (density) higher than that of the n type impurity contained in drift layer 3. $P^+$ regions 6, which include main surface 3A, are surrounded by well regions 4 and are formed adjacent to $n^+$ regions 5 within the pair of well regions 4 respectively. Each of $p^+$ regions 6 contains a p type impurity such as Al at a concentration (density) higher than that of the p type impurity contained in each of well regions 4. Buffer layer 2, drift layer 3, well regions 4, $n^+$ regions 5, and $p^+$ regions 6 constitute an active layer 7.

Referring to Fig. 1, MOSFET 100 further includes: a gate oxide film 91 serving as a gate insulating film; a gate electrode 93; a pair of source contact electrodes 92; an interlayer insulating film 94; a source wire 95; and a drain electrode 96.

Gate oxide film 91 is formed on and in contact with main surface 3A of drift layer 3 so as to extend from a location on the upper surface of one $n^+$ region 5 to a location on the upper surface of the other $n^+$ region 5. Gate oxide film 91 is made of, for example, silicon dioxide ($SiO_2$).

Gate electrode 93 is disposed in contact with gate oxide film 91 so as to extend from a location over one $n^+$ region 5 to a location over the other $n^+$ region 5. Further, gate electrode 93 is made of a conductor such as polysilicon having an impurity added therein or Al.

Source contact electrodes 92 are disposed in contact with main surface 3A, extend from respective locations on the pair of n+ regions 5 in the directions getting away from gate oxide film 91, and reach locations on p+ regions 6. Each of source contact electrodes 92 is made of a material capable of ohmic contact with n+ regions 5, such as $Ni_xSi_y$ (nickel silicide).

Interlayer insulating film 94 is formed to surround gate electrode 93 over main surface 3A of drift layer 3, and extends from a location over one well region 4 to a location over the other well region 4. Interlayer insulating film 94 is made of, for example, silicon dioxide ($SiO_2$), which is an insulator.

Source wire 95 surrounds interlayer insulating film 94 over main surface 3A of drift layer 3, and extends onto the upper surfaces of source contact electrodes 92. Source wire 95 is made of a conductor such as Al, and is electrically connected to n+ regions 5 via source contact electrodes 92.

Drain electrode 96 is formed in contact with the main surface of silicon carbide substrate 1 opposite to the side at which drift layer 3 is formed. Drain electrode 96 is made of a material capable of ohmic contact with silicon carbide substrate 1, such as $Ni_xSi_y$. Drain electrode 96 is electrically connected to silicon carbide substrate 1.

The following describes operations of MOSFET 100. Referring to Fig. 1, when the drain electrode is fed with a voltage while gate electrode 93 has a voltage smaller than a threshold voltage, i.e., during the OFF state, a pn junction of well regions 4 and drift layer 3 just below gate oxide film 91 is reverse-biased. Accordingly, MOSFET 100 is in the non-conductive state. On the other hand, when gate electrode 93 is fed with a positive voltage equal to or greater than the threshold voltage, an inversion layer is formed in a channel region near locations at which well regions 4 make contact with gate oxide film 91. As a result, n+ regions 5 and drift layer 3 are electrically connected to one another, whereby a current flows between source wire 95 and drain electrode 96.

Referring to Fig. 2, in the present embodiment, silicon carbide substrate 1 constituting MOSFET 100 includes a base layer 10 made of silicon carbide, and a SiC layer 20 made of single-crystal silicon carbide and arranged on one main surface 10A of base layer 10. Base layer 10 has an impurity concentration greater than $2 \times 10^{19}$ cm$^{-3}$, and SiC layer 20 has an impurity concentration greater than $5 \times 10^{18}$ cm$^{-3}$ and smaller than $2 \times 10^{19}$ cm$^{-3}$. Hence, MOSFET 100 in the present embodiment is a semiconductor device allowing for reduced on-resistance while restraining stacking fault from being produced due to heat treatment in the device manufacturing process. It should be noted that there is a boundary between base layer 10 and SiC layer 20 and defect density may be discontinuous at this boundary. Further, base layer 10 employed may be made of, for example, single-crystal silicon carbide, polycrystal silicon carbide, amorphous silicon carbide, a silicon carbide sintered compact, or a combination thereof.

Here, in the MOSFET 100, base layer 10 may be made of single-crystal silicon carbide. SiC layer 20 preferably has a micro pipe density smaller than that of base layer 10. Further, SiC layer 20 preferably has a threading screw dislocation density smaller than that of base layer 10. Further, SiC layer 20 preferably has a threading edge dislocation density smaller than that of base layer 10. Further, SiC layer 20 preferably has a basal plane dislocation density smaller than that of base layer 10. Further, SiC layer 20 preferably has a composite dislocation density smaller than that of base layer 10. Further, SiC layer 20 preferably has a stacking fault density smaller than that of base layer 10. Further, SiC layer 20 preferably has a point defect density smaller than that of base layer 10.

Thus, as compared with base layer 10, SiC layer 20 has the reduced defect densities such as the micro pipe density, the threading screw dislocation density, the threading edge dislocation density, the basal plane dislocation density, the composite dislocation density, the stacking fault density, and the point defect density. Such a SiC layer 20 allows a high-quality active layer 7 to be formed on SiC layer 20.

Further, in MOSFET 100, base layer 10 is made of single-crystal silicon carbide, and the half width of X-ray rocking curve of SiC layer 20 may be smaller than that of base layer 10.

Accordingly, a single-crystal silicon carbide having predetermined uniform shape and size and having relatively low crystallinity is employed as base layer 10 of silicon carbide substrate 1, while a single-crystal silicon carbide having a high crystallinity and not having the desired shape or the like is effectively utilized as SiC layer 20. As a result, the manufacturing cost of the semiconductor device can be reduced.

Further, in silicon carbide substrate 1 of MOSFET 100, main surface 20A of SiC layer 20 opposite to base layer 10 preferably has an off angle of not less than 50° and no more than 65° relative to the {0001} plane. This restrains formation of interface state in the vicinity of an interface of active layer 7 with gate oxide film 91, in the case where active layer 7 is formed by means of epitaxial growth and ion implantation of impurity, thereby achieving reduced on-resistance of MOSFET 100. The vicinity of the interface serves as a channel region.

Further, in silicon carbide substrate 1 of MOSFET 100. main surface 20A of SiC layer 20 opposite to base layer 10 has an off orientation forming an angle of 5° or smaller relative to the <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer (active layer 7) to be formed readily on silicon carbide substrate 1.

Further, in silicon carbide substrate 1 of MOSFET 100, main surface 20A of SiC layer 20 opposite to base layer 10 preferably has an off angle of not less than -3° and not more than 5° relative to the {03-38} plane in the <-100> direction. Accordingly, channel mobility can be further improved in the case where MOSFET 100 is fabricated using silicon carbide substrate 1.

Meanwhile, in silicon carbide substrate 1 of MOSFET 100, main surface 20A of SiC layer 20 opposite to base layer 10 may have an off orientation forming an angle of not more than 5° relative to the <1 -20> direction.

<11-20> is a representative off orientation in a silicon carbide substrate, as with the <1-100> direction. Variation in the off orientation resulting from variation in the slicing process of the process of manufacturing the substrate is adapted to be $\pm 5°$, which allows an epitaxial growth layer (active layer 7) to be formed readily on SiC layer 20.

Here, in silicon carbide substrate 1 constituting MOSFET 100, the impurity contained in base layer 10 may be different from that contained in SiC layer 20. In this way, MOSFET 100 can be obtained which includes silicon carbide substrate 1 containing impurities appropriately depending on intended purpose of use. Further, the impurity contained in base layer 10 may be nitrogen or phosphorus, whereas the impurity contained in SiC layer 20 may be also nitrogen or phosphorus.

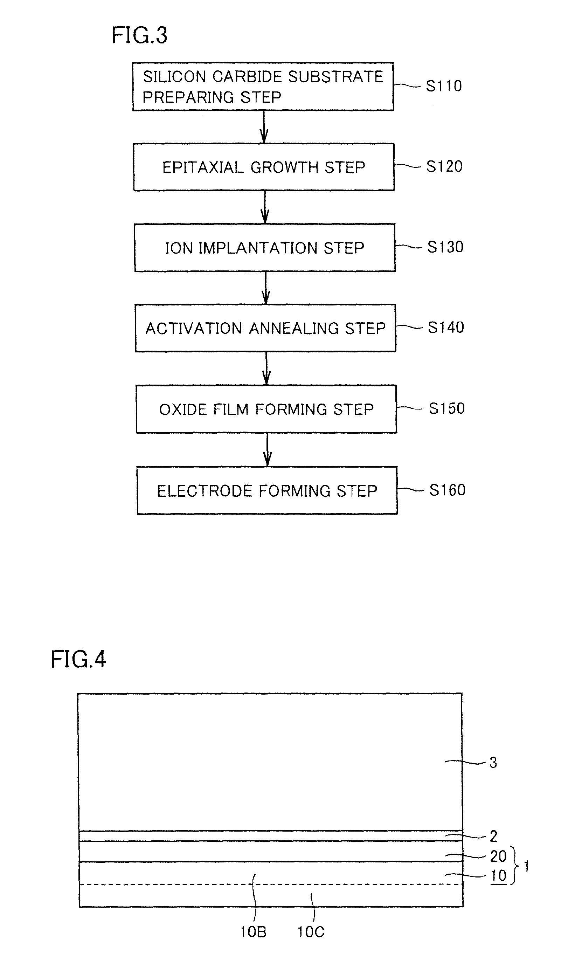

The following describes one exemplary method for manufacturing MOSFET 100 in the first embodiment, with reference to Fig. 3-Fig. 6. Referring to Fig. 3, in the method for manufacturing MOSFET 100 in the present embodiment, a silicon carbide substrate preparing step is first performed as a step (S110). In this step (S110), referring to Fig. 4, silicon carbide substrate 1 is prepared which includes base layer 10 made of single-crystal silicon carbide, and SiC layer 20 made of single-crystal silicon carbide and disposed on base layer 10. Base layer 10 has an impurity concentration greater than $2 \times 10^{19}$ cm$^{-3}$, whereas SiC layer 20 has an impurity concentration greater than $5 \times 10^{18}$ cm$^{-3}$ and smaller than $2 \times 10^{19}$ cm$^{-3}$. In silicon carbide substrate 1 prepared in this step (S110), the following base layer 10 may be employed instead of base layer 10 entirely formed of single-crystal silicon carbide. That is, base layer 10 employed includes: a single-crystal layer 10B made of single-crystal silicon carbide and including main surface 10A facing SiC layer 20, and the other region 10C made of polycrystal silicon carbide, amorphous silicon carbide, or a silicon carbide sintered compact. Further, instead of base layer 10 entirely made of single-crystal silicon carbide, there may be employed a base layer 10 entirely made of polycrystal silicon carbide, amorphous silicon carbide, or a silicon carbide sintered compact. A method for manufacturing silicon carbide substrate 1 will be described below.

Next, as a step (S120), an epitaxial growth step is performed. In this step (S120), referring to Fig. 4, buffer layer 2 and drift layer 3 each made of silicon carbide are sequentially formed on and over one main surface of silicon carbide substrate 1 by means of epitaxial growth.

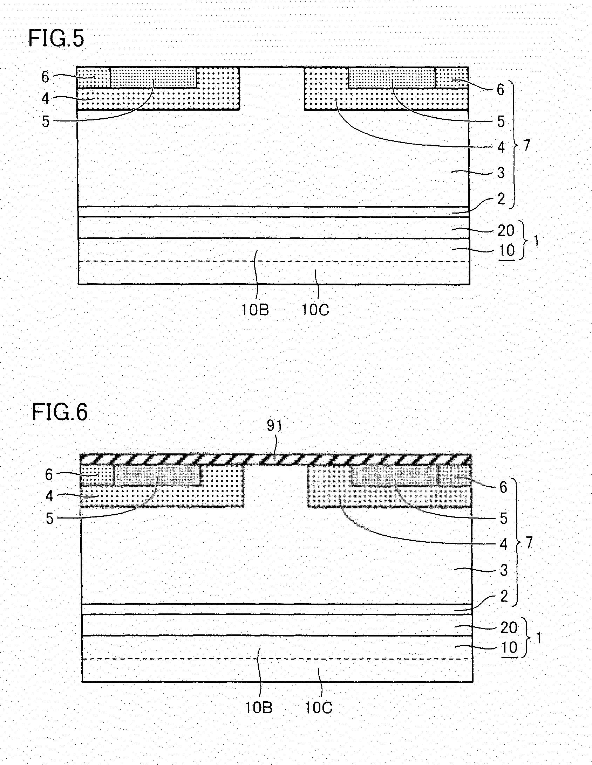

Next, as a step (S130), an ion implantation step is performed. In this step (S130), referring to Fig. 4 and Fig. 5, ion implantation is first performed to form well regions 4. Specifically, Al (aluminum) ions are implanted into drift layer 3,thereby forming well regions 4. Next, ion implantation is performed to form n$^+$ regions 5. Specifically, for example, P (phosphorus) ions are implanted into well regions 4, thereby forming n$^+$ regions 5 within well regions 4. Further, ion implantation is performed to form p$^+$ regions 6. Specifically, for example, Al ions are implanted into well regions 4, thereby forming p$^+$ regions 6 within well regions 4. The ions can be implanted using a mask layer formed on the main surface of drift layer 3, made of silicon dioxide (SiO$_2$) and having openings at desired regions for the ion implantation, for example.

Next, as a step (S140), an activation annealing step is performed. In this step (S140), for example, heat treatment is performed by heating them to 1700°C in an inert gas atmosphere such as argon for 30 minutes. Accordingly, the impurities implanted in the above-described step (S130) are activated.

Next, as a step (S150), an oxide film forming step is performed. In this step (S150), referring to Fig. 5 and Fig. 6, for example, heat treatment is performed by heating to 1300°C in an oxygen atmosphere for 60 minutes, thereby forming oxide film 91 (gate oxide film).

Next, as a step (S160), an electrode forming step is performed. Referring to Fig. 1, in this step (S160), first, gate electrode 93 is formed by means of a CVD method, photolithography, and etching. Gate electrode 93 is made of a conductor such as polysilicon having an impurity added therein at a high concentration, for example. Thereafter, for example, by means of the CVD method, interlayer insulating film 94 made of SiO$_2$ that is an insulator is formed to surround gate electrode 93 over main surface 3A. Next, by means of photolithography and etching, portions of interlayer insulating film 94 and oxide film 91 are removed from the regions in which source electrodes 92 are to be formed. Next, for example, a nickel (Ni) film is formed by means of an evaporation method and is heated to be silicided, thereby forming source contact electrodes 92 and drain electrode 96. Then, for example, using the evaporation method, source wire 95 made of Al that is a conductor is formed to surround interlayer insulating film 94 over main surface 3A and extend to the locations over and on the upper surfaces of n$^+$ regions 5 and source contact electrodes 92. With the above-described procedure, MOSFET 100 in the present embodiment is completed.

In the case where there is adopted in step (S110) base layer 10 that includes single-crystal layer 10B made of single-crystal silicon carbide and including main surface 10A facing SiC layer 20 and that includes the other region 10C made of polycrystal silicon carbide, amorphous silicon carbide, or silicon carbide sintered compact, a step of removing the other region 10C may be performed. In this way, MOSFET 100 including base layer 10 made of single-crystal silicon carbide can be obtained (see Fig. 1). Meanwhile, the step of removing region 10C described above may not be performed. In this case, a non single-crystal layer (corresponding to region 10C described above) made of polycrystal silicon carbide, amorphous silicon carbide, or silicon carbide sintered compact is formed on the main surface of base layer 10 opposite to SiC layer 20 in MOSFET 1 shown in Fig. 1 (i.e., as a lower layer in base layer 10 in Fig. 1). This non single-crystal layer does not have great influence over the characteristics of MOSFET 100 as long as the resistivity thereof is low. Hence, when such a manufacturing process is employed, manufacturing cost of MOSFET 100 can be reduced without great influence over the characteristics thereof.

On this occasion, the half width of X-ray rocking curve of SiC layer 20 may be smaller than that of single-crystal layer 10B. As such, SiC layer 20 having such a smaller half width of the X-ray rocking curve, i.e., having higher crystallinity than that of single-crystal layer 10B of base layer 10 is provided, thereby allowing a high-quality active layer 7 to be formed on SiC layer 20.

Further, SiC layer 20 may have a micro pipe density smaller than that of single-crystal layer 10B. Further, SiC layer 20 may have a dislocation density smaller than that of single-crystal layer 10B. Further, SiC layer 20 may have a threading screw dislocation density smaller than that of single-crystal layer 10B. Further, SiC layer 20 may have a threading edge dislocation density smaller than that of single-crystal layer 10B. Further, SiC layer 20 may have a basal plane dislocation density smaller than that of single-crystal layer 10B. Further, SiC layer 20 has a composite dislocation density smaller than that of single-crystal layer 10B. Further, SiC layer 20 may have a stacking fault density smaller than that of single-crystal layer 10B. Further, SiC layer 20 may have a point defect density smaller than that of single-crystal layer 10B.

Thus, as compared with single-crystal layer 10B of base layer 10, SiC layer 20 has the reduced defect densities such as the micro pipe density, the threading screw dislocation density, the threading edge dislocation density, the basal plane dislocation density, the composite dislocation density, the stacking fault density, and the point defect density. Accordingly, MOSFET 100 including high-quality layer 7 can be obtained.

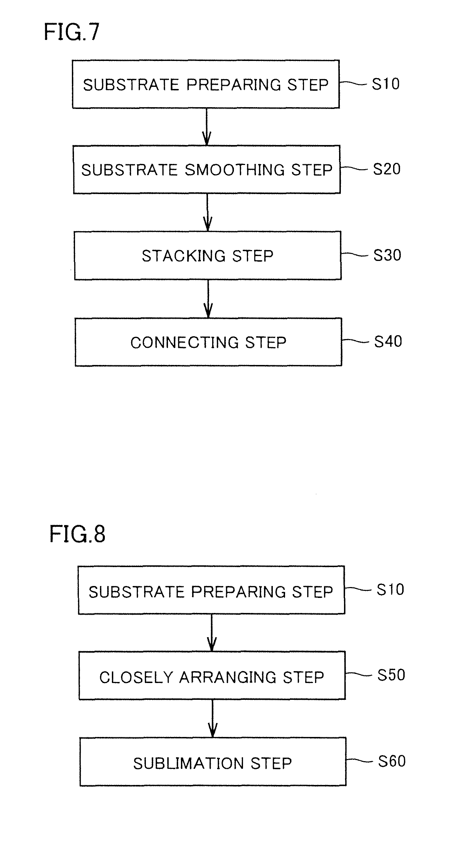

The following describes the silicon carbide substrate preparing step performed as step (S110) described above. Referring to Fig. 7, in manufacturing the silicon carbide substrate in the present embodiment, first, as step (S10), the substrate preparing step is performed. In this step (S10), referring to Fig. 2, base substrate 10 formed of single-crystal silicon carbide and SiC substrate 20 formed of single-crystal silicon carbide are prepared.

SiC substrate 20 has main surface 20A, which will be the main surface of silicon carbide substrate 1 that will be obtained by this manufacturing method. Hence, on this occasion, the plane orientation of main surface 20A of SiC substrate 20 is selected in accordance with desired plane orientation of main surface 20A. Here, for example, a SiC substrate 20 having a main surface corresponding to the {03-38} plane is prepared. Meanwhile, a substrate having an impurity concentration greater than $2 \times 10^{19}$ cm$^{-3}$ is adopted as base substrate 10. Further, for SiC substrate 20, a substrate is employed which has an impurity concentration greater than $5 \times 10^{18}$ cm$^{-3}$ and smaller than $2 \times 10^{19}$ cm$^{-3}$.

Next, a substrate smoothing step is performed as a step (S20). Step (S20) is not an essential step, but can be performed when the smoothness of base substrate 10 and/or SiC substrate 20 prepared in step (S10) is insufficient. Specifically, for example, the main surface(s) of base substrate 10 and/or SiC substrate 20 are polished.

Meanwhile, step (S20) may be omitted, i.e., step (S30) may be performed without polishing the main surfaces of base substrate 10 and SiC substrate 20, which are to be brought into contact with each other. This reduces manufacturing cost of silicon carbide substrate 1. Further, for removal of damaged layers located in surfaces formed by slicing upon fabrication of base substrate 10 and SiC substrate 20, a step of removing the damaged layers may be performed by, for example, etching instead of step (S20) or after step (S20), and then step (S30) described below may be performed.

Next, a stacking step is performed as step (S30). In this step (S30), referring to Fig. 2, base substrate 10 and SiC substrate 20 are stacked on each other to bring their main surfaces 10A, 20B into contact with each other, thereby fabricating a stacked substrate.

Next, as step (S40), a connecting step is performed. In this step (S40), by heating the stacked substrate to fall within, for example, a range of temperature equal to or greater than the sublimation temperature of silicon carbide, base substrate 10 and SiC substrate 20 are connected to each other. In this way, referring to Fig. 2, silicon carbide substrate 1 including base layer 10 and SiC layer 20 is completed. Further, by heating to the temperature equal to or greater than the sublimation temperature, base substrate 10 and SiC substrate 20 can be connected to each other readily even in the case where step (S20) is not performed and step (S30) is performed without polishing the main surfaces of base substrate 10 and SiC substrate 20 which are to be brought into contact with each other. It should be noted that in this step (S40), the stacked substrate may be heated in an atmosphere obtained by reducing pressure of the atmospheric air. This reduces manufacturing cost of silicon carbide substrate 1.

Further, heating temperature for the stacked substrate in step (S40) is preferably not less than 1800°C and not more than 2500°C. If the heating temperature is lower than 1800°C, it takes a long time to connect base substrate 10 and SiC substrate 20, which results in decreased efficiency in manufacturing silicon carbide substrate 1. On the other hand, if the heating temperature exceeds 2500°C, surfaces of base substrate 10 and SiC substrate 20 become rough, which may result in generation of a multiplicity of crystal defects in silicon carbide substrate 1 to be fabricated. In order to improve efficiency in manufacturing while restraining generation of defects in silicon carbide substrate 1, the heating temperature for the stacked substrate in step (S40) is set at not less than 1900°C and not more than 2100°C. Further, in this step (S40), the stacked substrate may be heated under a pressure higher than $10^{-1}$ Pa and lower than $10^4$ Pa.

This can accomplish the above-described connection using a simple device, and provide an atmosphere for accomplishing the connection for a relatively short time, thereby achieving reduced manufacturing cost of silicon carbide substrate 1. Further, the atmosphere upon the heating in step (S40) may be inert gas atmosphere. In the case where the atmosphere is the inert gas atmosphere, the inert gas atmosphere preferably contains at least one selected from a group consisting of argon, helium, and nitrogen.

Further, in the method for manufacturing the MOSFET 100 in the present embodiment, MOSFET 100 is manufactured using silicon carbide substrate I thus obtained.

(Second Embodiment)

As a second embodiment, the following describes another method for manufacturing the silicon carbide substrate constituting the semiconductor device of the present invention with reference to Fig. 8-Fig. 11. A method for manufacturing a silicon carbide substrate in the second embodiment is performed in basically the same manner as in the first embodiment. However, the method for manufacturing the silicon carbide substrate in the second embodiment is different from that of the first embodiment in terms of a process of forming base substrate 10.

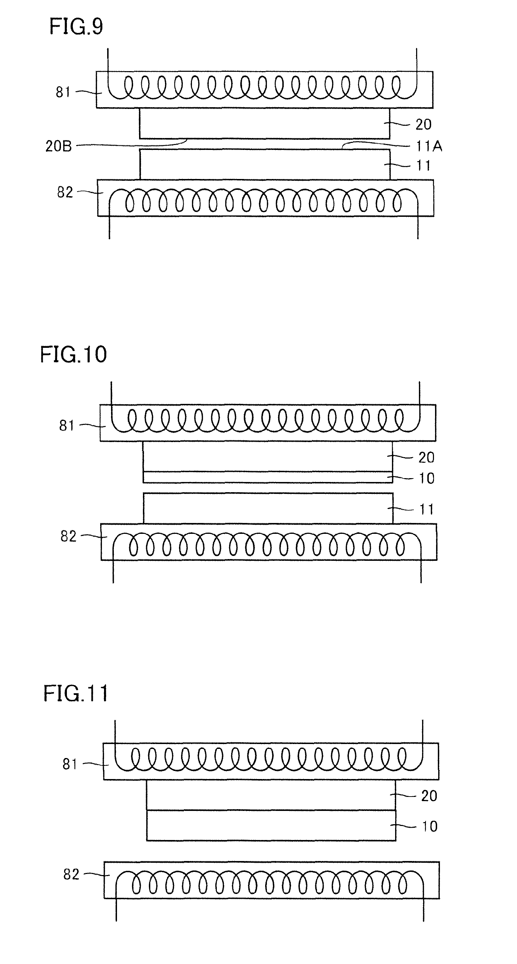

Referring to Fig. 8, the substrate preparing step is first performed as step (S10) in the method for manufacturing the silicon carbide substrate in the second embodiment. In step (S10), referring to Fig. 9, SiC substrate 20 is prepared as with the first embodiment, and a material substrate 1 made of silicon carbide is prepared. Material substrate 11 may be made of single-crystal silicon carbide or polycrystal silicon carbide, or may be a sintered compact of silicon carbide. Further, instead of material substrate 11, material powder made of silicon carbide can be employed.

Next, as a step (S50), a closely arranging step is performed. In this step (S50), referring to Fig. 9, SiC substrate 20 and material substrate 11 are held by a first heater 81 and a second heater 82 disposed face to face with each other. Here, an appropriate value of a space between SiC substrate 20 and material substrate 11 is considered to be associated with a mean free path for a sublimation gas obtained upon heating in a below-described step (S60). Specifically, the average value of the space between SiC substrate 20 and material substrate 11 can be set to be smaller than the mean free path for the sublimation gas obtained upon heating in the below-described step (S60). For example, strictly, a mean free path for atoms and molecules depends on atomic radius and molecule radius at a pressure of 1 Pa and a temperature of 2000°C, but is approximately several cm to several ten cm. Hence, realistically, the space is preferably set at several cm or smaller. More specifically, SiC substrate 20 and material substrate 11 are arranged close to each other such that their main surfaces face each other with a space of not less than 1 $\mu$m and not more than 1 cm therebetween. When the average value of the space is 1 cm or smaller, distribution in film thickness of base layer 10 can be reduced in the below-described step (S60). When the average value of the space is 1 mm or smaller, the distribution in film thickness of base layer 10 can be reduced further in the below-described step (S60). Furthermore, with the average value of the space being 1 $\mu$m or greater, there can be secured a sufficient space for sublimation of silicon carbide. It should be noted that this sublimation gas is a gas formed by sublimation of solid silicon carbide, and includes Si, $Si_2C$, and $SiC_2$, for example.

Next, as step (S60), a sublimation step is performed. In this step (S60), SiC substrate 20 is heated to a predetermined substrate temperature by first heater 81. Further, material substrate 11 is heated to a predetermined material temperature by second heater 82. On this occasion, material substrate 11 is heated to reach the material temperature, thereby sublimating SiC from the surface of the material substrate. On the other hand, the substrate temperature is set lower than the material temperature. Specifically, for example, the substrate temperature is set lower than the material temperature by not less than 1°C and not more than 100°C. The substrate temperature is preferably 1800°C or greater and 2500°C or smaller. Accordingly, as shown in Fig. 10, SiC sublimated from material substrate 11 in the form of gas reaches the surface of SiC substrate 20 and is accordingly solidified thereon, thereby forming base layer 10. With this state being maintained, as shown in Fig. 11, all the SiC constituting material substrate 11 is sublimated and is transferred onto the surface of SiC substrate 20. Accordingly, step (S60) is completed, thereby completing silicon carbide substrate 1 shown in Fig. 2.

(Third Embodiment)

The following describes still another embodiment of the present invention, i.e., a third embodiment. A semiconductor device in the third embodiment has basically the same structure as that in the first embodiment. However, the semiconductor device of the third embodiment is different from that of the first embodiment in terms of its manufacturing method.

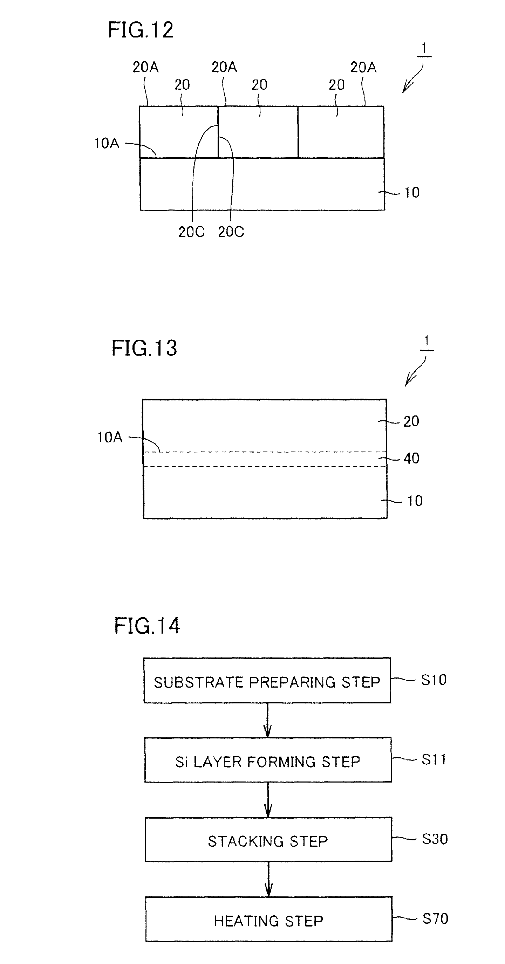

Specifically, a silicon carbide substrate different in structure from that of the first embodiment is prepared in the silicon carbide substrate preparing step performed as step (S110) in the method for manufacturing the semiconductor device (for example, MOSFET) in the third embodiment. Referring to Fig. 12, in silicon carbide substrate 1 prepared in the third embodiment, a plurality of SiC layers 20 are arranged side by side when viewed in a planar view. In other words, the plurality of SiC layers 20 are arranged along main surface 10A of base layer 10. More specifically, the plurality of SiC layers 20 are arranged in the form of a matrix on base layer 10 such that adjacent SiC layers 20 are in contact with each other. Accordingly, silicon carbide substrate I of the present embodiment can be handled as a substrate having high-quality SiC layers 20 and a large diameter. Utilization of such a silicon carbide substrate 1 allows for efficient manufacturing process of semiconductor devices. Further, referring to Fig. 12, each of adjacent SiC layers 20 has an end surface 20C substantially perpendicular to main surface 20A of SiC layer 20. In this way, silicon carbide substrate 1 of the present embodiment can be readily manufactured. Here, for example, when end surface 20C and main surface 20A form an angle of not less than 85° and not more than 95°, it can be determined that end surface 20C and main surface 20A are substantially perpendicular to each other. It should be noted that silicon carbide substrate 1 in the third embodiment can be manufactured in a manner similar to that in the first embodiment or the second embodiment as follows. That is, in step (S30) of the first embodiment, a plurality of SiC substrates 20 each having an end surface 20C substantially perpendicular to main surface 20A thereof are arranged side by side when viewed in a planar view (see Fig. 2). Alternatively, in step (S50) of the second embodiment, a plurality of SiC substrates 20 each having an end surface 20C substantially perpendicular to main surface 20A thereof are arranged side by side on and held by first heater 81 (see Fig. 9).

Further, in the method for manufacturing the semiconductor device (MOSFET 100) in the present embodiment, MOSFET 100 is manufactured using silicon carbide substrate 1 thus obtained. Here, by forming active layer 7 and the like on SiC layers 20 of silicon carbide substrate 1 shown in Fig. 12, a plurality of MOSFETs 100 arranged side by side when viewed in a planar view are fabricated. On this occasion, each MOSFET 100 is fabricated so as not to extend across a boundary region between adjacent SiC layers 20.

(Fourth Embodiment)

The following describes yet another embodiment of the present invention, i.e., a fourth embodiment. A MOSFET 100 (semiconductor device) in the fourth embodiment has basically the same structure and provides basically the same effects as those of MOSFET 100 in the first embodiment. However, MOSFET 100 in the fourth embodiment is different from that of the first embodiment in terms of structure of silicon carbide substrate 1.

Namely, referring to Fig. 13, in silicon carbide substrate 1 in the fourth embodiment, an amorphous SiC layer 40 is disposed between base layer 10 and SiC layer 20 as an intermediate layer made of amorphous SiC. Then, base layer 10 and SiC layer 20 are connected to each other by this amorphous SiC layer 40. Amorphous SiC layer 40 thus existing facilitates fabrication of silicon carbide substrate 1 in which base layer 10 and SiC layer 20 different in impurity concentration are stacked on each other.

The following describes a method for manufacturing silicon carbide substrate 1 in the fourth embodiment. Referring to Fig. 14, in the method for manufacturing silicon carbide substrate 1 in the fourth embodiment, the substrate preparing step is performed as step (S10) in the same way as in the first embodiment, so as to prepare base substrate 10 and SiC substrate 20.

Next, a Si layer forming step is performed as a step (S11). In this step (S11), a Si layer having a thickness of 100 nm is formed on one main surface of base substrate 10 prepared in step (S10), for example. This Si layer can be formed using a sputtering method, for example.

Next, a stacking step is performed as step (S30). In this step (S30), SiC substrate 20 prepared in step (S10) is placed on the Si layer formed in step (S11). In this way, a stacked substrate is obtained in which SiC substrate 20 is provided over base substrate 10 with the Si layer interposed therebetween.

Next, as a step (S70), a heating step is performed. In this step (S70), the stacked substrate fabricated in step (S30) is heated, for example, in a mixed gas atmosphere of hydrogen gas and propane gas under a pressure of $1 \times 10^3$ Pa at approximately 1500°C for 3 hours. Accordingly, the Si layer is supplied with carbon as a result of diffusion mainly from base substrate 10 and SiC substrate 20, thereby forming amorphous SiC layer 40 as shown in Fig. 13. Accordingly, silicon carbide substrate 1 of the fourth embodiment can be readily manufactured in which base layer 10 and SiC layer 20 different in impurity concentration are connected to each other by amorphous SiC layer 40.

(Fifth Embodiment)

The following describes yet another embodiment of the present invention, i.e., a fifth embodiment. A MOSFET 100 (semiconductor device) in the fifth embodiment has basically the same structure and provides basically the same effects as those of MOSFET 100 in the first embodiment. However, MOSFET 100 in the fifth embodiment is different from that of the first embodiment in terms of structure of silicon carbide substrate 1.

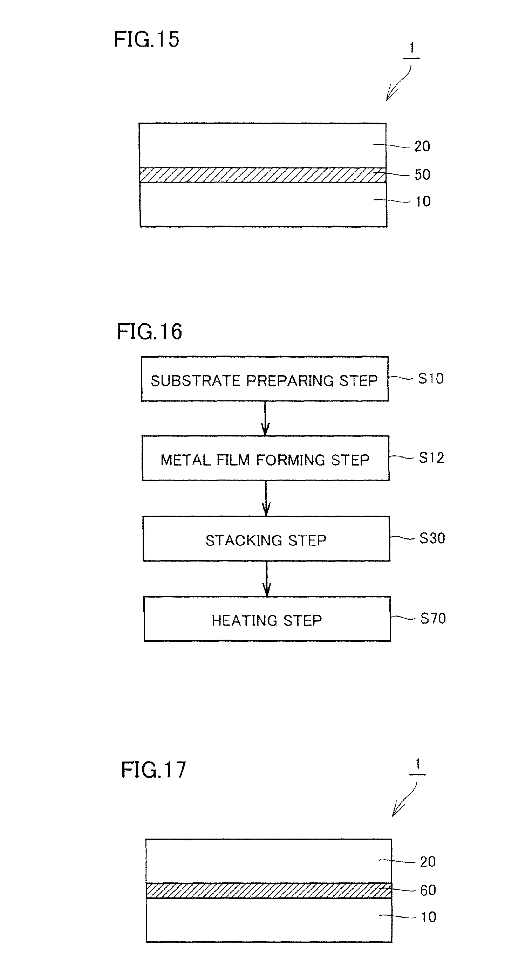

Specifically, referring to Fig. 15, silicon carbide substrate 1 of the fifth embodiment is different from that of the first embodiment in that an ohmic contact layer 50 is formed between base layer 10 and SiC layer 20 as an intermediate layer obtained by siliciding at least a part of a metal layer. Then, base layer 10 and SiC layer 20 are connected to each other by this ohmic contact layer 50. Ohmic contact layer 50 thus existing facilitates fabrication of silicon carbide substrate 1 in which base layer 10 and SiC layer 20 different in impurity concentration are stacked on each other.

The following describes a method for manufacturing silicon carbide substrate 1 in the fifth embodiment. Referring to Fig. 16, in the method for manufacturing silicon carbide substrate 1 in the fifth embodiment, the substrate preparing step is performed as step (S10) in the same way as in the first embodiment, so as to prepare base substrate 10 and SiC substrate 20.

Next, a metal film forming step is performed as a step (S12). In this step (S12), the metal film is formed by, for example, depositing the metal on one main surface of base substrate 10 prepared in step (S10). This metal film contains a metal which forms silicide by, for example, heating. For example, the metal film contains at least one or more of nickel, molybdenum, titanium, aluminum, and tungsten.

Next, a stacking step is performed as step (S30). In this step (S30), SiC substrate 20 prepared in step (S10) is placed on the metal film formed in step (S12). In this way, a stacked substrate is obtained in which SiC substrate 20 is provided over base substrate 10 with the metal film interposed therebetween.

Next, as a step (S70), a heating step is performed. In this step (S70), the stacked substrate fabricated in step (S30) is heated to approximately 1000°C in an inert gas atmosphere such as argon, for example. Accordingly, at least part of the metal film (its region in contact with base substrate 10 and its region in contact with the SiC substrate) is silicided, thereby forming ohmic contact layer 50 making ohmic contact with base layer 10 and SiC layer 20. Accordingly, silicon carbide substrate 1 of the fifth embodiment can be readily manufactured in which base layer 10 and SiC layer 20 different in impurity concentration are connected to each other by ohmic contact layer 50.

(Sixth Embodiment)

The following describes yet another embodiment of the present invention, i.e., a sixth embodiment. A MOSFET 100 (semiconductor device) in the sixth embodiment has basically the same structure and provides basically the same effects as those of MOSFET 100 in the first embodiment. However, MOSFET 100 in the sixth embodiment is different from that of the first embodiment in terms of structure of silicon carbide substrate 1.

Specifically, referring to Fig. 17, silicon carbide substrate 1 of the sixth embodiment is different from that of the first embodiment in that a carbon layer 60 is formed between base layer 10 and SiC layer 20 as an intermediate layer. Then, base layer 10 and SiC layer 20 are connected to each other by this carbon layer 60. Carbon layer 60 thus existing facilitates fabrication of silicon carbide substrate 1 in which base layer 10 and SiC layer 20 different in impurity concentration are stacked on each other.

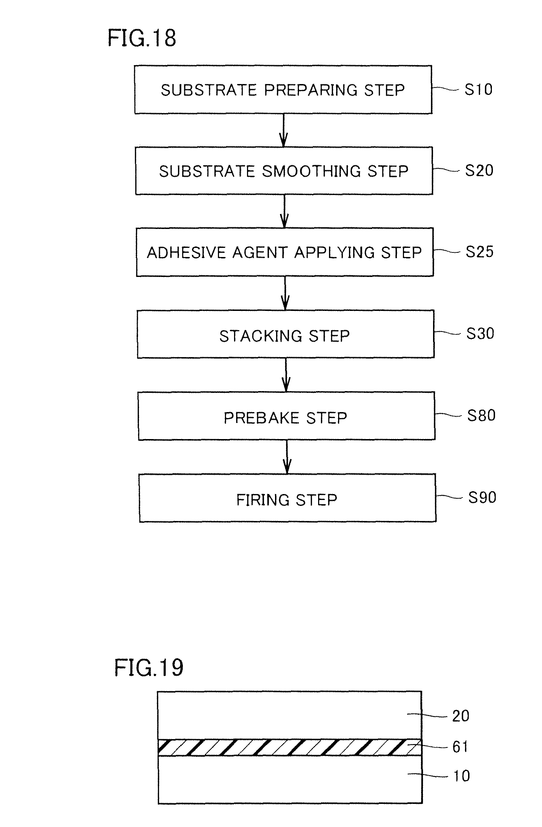

The following describes a method for manufacturing silicon carbide substrate 1 in the sixth embodiment. Referring to Fig. 18, first, step (S10) is performed in the same way as in the first embodiment, and then step (S20) is performed as required in the same way as in the first embodiment.

Next, as a step (S25), an adhesive agent applying step is performed. In this step (S25), referring to Fig. 19, for example, a carbon adhesive agent is applied to the main surface of base substrate 10, thereby forming a precursor layer 61. The carbon adhesive agent can be formed of, for example, a resin, graphite particles, and a solvent. Here, an exemplary resin usable is a resin formed into non-graphitizable carbon by heating, such as a phenol resin. An exemplary solvent usable is phenol, formaldehyde, ethanol, or the like. Further, the carbon adhesive agent is preferably applied at an amount of not less than 10 mg/cm$^2$ and not more than 40mg/cm$^2$, more preferably, not less than 20 mg/cm$^2$ and not more than 30 mg/cm$^2$. Further, the carbon adhesive agent applied preferably has a thickness of not more than 100 $\mu$m, more preferably, not more than 50 $\mu$m.

Next, a stacking step is performed as step (S30). In this step (S30), referring to Fig. 19, SiC substrate 20 is placed on and in contact with precursor layer 61 formed on and in contact with the main surface of base substrate 10, thereby fabricating a stacked substrate.

Next, as a step (S80), a prebake step is performed. In this step (S80), the stacked substrate is heated, thereby removing the solvent component from the carbon adhesive agent constituting precursor layer 61. Specifically, for example, while applying a load to the stacked substrate in the thickness direction thereof, the stacked substrate is gradually heated to fall within a range of temperature exceeding the boiling point of the solvent component. Preferably, this heating is performed with base substrate 10 and SiC substrate 20 being pressed against each other using a clamp or the like. Further, by performing the prebaking (heating) as long as possible, the adhesive agent is degassed to improve strength in adhesion.

Next, as a step (S90), a firing step is performed. In this step (S90), the stacked substrate with precursor layer 61 heated and accordingly prebaked in step (S80) are heated to a high temperature, preferably, not less than 900°C and not more than 1100°C, for example, 1000°C for preferably not less than 10 minutes and not more than 10 hours, for example, for 1 hour, thereby firing precursor layer 61. Atmosphere employed upon the firing can be an inert gas atmosphere such as argon. The pressure of the atmosphere can be, for example, atmospheric pressure. Accordingly, precursor layer 61 is formed into a carbon layer 60 made of carbon. As a result, referring to Fig. 17, silicon carbide substrate 1 of the sixth embodiment is obtained in which base substrate (base layer) 10 and SiC substrate (SiC layer) 20 are connected to each other by carbon layer 60.

It should be noted that in each of the foregoing embodiments, the vertical type MOSFET has been illustrated as one exemplary semiconductor device of the present invention, but the semiconductor device of the present invention is not limited to this and is widely applicable to vertical type semiconductor devices in each of which a current flows in the thickness direction of the silicon carbide substrate.

It should be noted that in silicon carbide substrate 1, the crystal structure of silicon carbide constituting SiC layer 20 is preferably of hexagonal system, more preferably, 4H-SiC. Further, base layer 10 and SiC layer 20 (as well as adjacent SiC layers 20 in the case where a plurality of SiC layers 20 are provided) are preferably made of silicon carbide single-crystal having the same crystal structure. In this way, by employing silicon carbide single-crystal of the same crystal structure for base layer 10 and SiC layer 20, physical properties such as a thermal expansion coefficient become the same therebetween, thereby preventing warpage of silicon carbide substrate 1, separation of base layer 10 and SiC layer 20, or separation of SiC layers 20 in the processes of manufacturing silicon carbide substrate 1 and manufacturing a semiconductor device using silicon carbide substrate 1.

Further, the silicon carbide single-crystals respectively constituting SiC layer 20 and base layer 10 (as well as adjacent SiC layers 20 in the case where a plurality of SiC layers 20 are provided) preferably have c axes forming an angle of less than 1°, more preferably, less than 0.1°. Further, it is preferable that the c planes of the respective silicon carbide single-crystals thereof are not displaced from each other in the plane.

Further, base layer (base substrate) 10 of silicon carbide substrate 1 used to manufacture the semiconductor device such as MOSFET 100 preferably has a diameter of 2 inches or greater, more preferably, 6 inches or greater. Furthermore, silicon carbide substrate 1 preferably has a thickness of not less than 200 $\mu$m and not more than 1000 $\mu$m, more preferably, not less than 300 $\mu$m and not more than 700 $\mu$m. Further, SiC layer 20 preferably has a resistivity of 50 m$\Omega$cm or smaller, more preferably, 20 m$\Omega$cm or smaller.

[Examples]

(Example 1)

The following describes an example 1. Calculation was done to estimate the effect of reducing the on-resistance in the semiconductor device of the present invention. Specifically, the on-resistance was determined assuming that MOSFET 100 of the first embodiment employs silicon carbide substrate 1 including: base layer 10 having a thickness of 200 $\mu$m and having an n type impurity density of $1 \times 10^{20}$ cm$^{-3}$; and SiC layer 20 having a thickness of 200 $\mu$m and having an n type impurity density of $1 \times 10^{19}$ cm$^{-3}$, wherein SiC layer 20 has a main surface facing active layer 7 and corresponding to the {03-38} plane (example A). Meanwhile, for comparison, on-resistance of a conventional MOSFET was also determined (comparative example A). The conventional MOSFET employs a silicon carbide substrate having a thickness of 400 $\mu$m, having an n type impurity density of $1 \times 10^{19}$ cm$^{-3}$, and having a main surface facing its active layer and corresponding to the {0001} plane. Here, in each of example A and comparative example A, the channel length was set at 1.0 $\mu$m, and the drift layer was set to have a thickness of 10 $\mu$m and was set to have an impurity concentration of $1 \times 10^{16}$ cm$^{-3}$.

Further, the substrate resistance and the drift resistance of the drift layer, i.e., series resistance, were determined as follows. That is, first, the following relation is established, assuming that electron density is represented by $n_{n0}$, positive hole density is represented by $p_{p0}$, effective density of states of electrons is represented by $N_c$, and effective density of states of positive holes is represented by $N_v$.

[Formula 1]

$$n_{n0} = N_c \exp\left(-\frac{E_c - E_f}{kT}\right)$$

$$p_{p0} = N_v \exp\left(-\frac{E_f - E_v}{kT}\right)$$

$$N_c = 2\left(\frac{2\pi m_n^* kT}{h^2}\right)^{3/2} M_c = 2.51 \times 10^{25}\left(\frac{m_n^*}{m} \cdot \frac{T}{300}\right)^{3/2} M_c$$

$$N_v = 2\left(\frac{2\pi m_p^* kT}{h^2}\right)^{3/2} = 2.51 \times 10^{25}\left(\frac{m_p^*}{m} \cdot \frac{T}{300}\right)^{3/2}$$

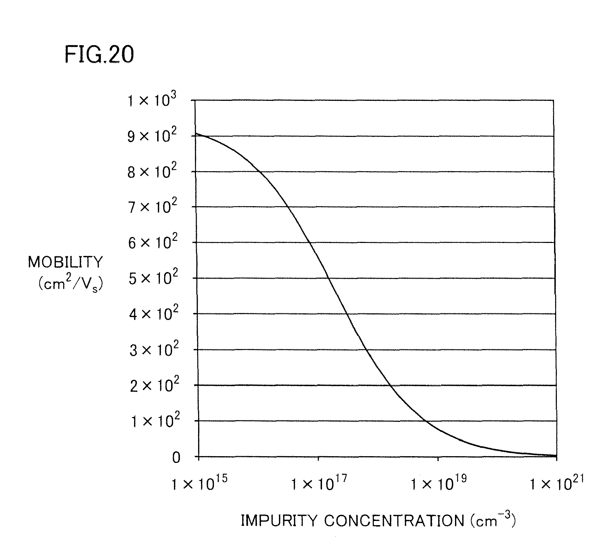

Here, in the n type 4H-SiC, a relation shown in Fig. 20 is established between the impurity concentration (density) and the mobility. Further, resistance R of the substrate can be determined by the following formula:

[Formula 2]

$$R = \frac{W}{q \cdot n_{n0} \cdot \mu_{el}}$$

From the substrate resistance and the other resistance component, a total resistance (on-resistance) can be determined. A result of the calculation described above is shown in Table 1.

[Table 1]

| | | Impurity Density ($cm^{-3}$) | Substrate Thickness ($\mu$m) | Substrate Resistance ($m\Omega cm^2$) | | Channel Mobility ($cm^2Vs$) | Channel Resistance ($m\Omega cm^2$) | Drift Resistance etc., ($m\Omega cm^2$) | Total Resistance ($m\Omega cm^2$) |
|---|---|---|---|---|---|---|---|---|---|
| Example A | Base Layer | $1 \times 10^{20}$ | 200 | 0.13 | 0.41 | 100 | 2 | 1 | 3.5 |
| | SiC layer | $1 \times 10^{19}$ | 200 | 0.28 | | | | | |
| Comparative Example A | | $1 \times 10^{19}$ | 400 | 0.55 | | 20 | 7 | 1 | 8.6 |

As shown in Table 1, it was confirmed that in the MOSFET of example A, i.e., the semiconductor device of the present invention, the on-resistance is reduced by approximately 60% as compared with that in the MOSFET of conventional comparative example A.

(Example 2)

The following describes an example 2. Calculation was done to estimate the effect of reducing contact resistance between the second electrode (drain electrode) and the silicon carbide substrate in the semiconductor device of the present invention. Here, in order to reduce the contact resistance between the electrode that is a metal and the silicon carbide substrate that is an n-type semiconductor and to attain ohmic contact therebetween, the following two approaches are contemplated:

    (1) Employing a metal having a small work function $\Phi$ to reduce Schottky barrier; and
    (2) Increasing impurity density in the semiconductor to obtain a small depletion layer width, thereby obtaining a thin Schottky barrier.

However, actually, it is not easy to employ approach (1). It is effective to employ approach (2) so as to increase tunnel current, thereby attaining the ohmic contact. The following describes a result of the calculation regarding the contact resistance between the electrode and the base layer, assuming that the semiconductor device of the present invention employs a silicon carbide substrate including a base layer having a high impurity concentration.

For contact resistance $R_c$, the following formula is established:

[Formula 3]

$$Rc = (dJ/dV)^{-1} \ \Omega \cdot cm^2$$

$$Rc \propto \exp\left(\Phi_b / N_d^{1/2}\right)$$

$$Rc = \exp\left[(4m^{1/2}\varepsilon_s \times \Phi_{bn})/(N_d^{1/2} \times h)\right]$$

$$Rc \propto \exp\left(\Phi_{bn} / N_d^{1/2}\right)$$

Namely, contact resistance $R_c$ exponentially depends on $\Phi_{bn}/(N_d^{1/2})$. By increasing impurity concentration (impurity density) $N_d$, contact resistance $R_c$ can be reduced. Specifically, for example, for the semiconductor device of the present invention, a contact resistance was determined between an electrode and a substrate (base layer) having an impurity concentration of $1 \times 10^{20}$ cm$^{-3}$ (example B). Meanwhile, for a conventional semiconductor device, a contact resistance was determined between an electrode and a substrate having an impurity concentration of $1 \times 10^{18}$ cm$^{-3}$ (comparative example B). It should be noted that an exemplary, usable metal constituting the electrode includes Ni (nickel) having a work function $\Phi$ of 5.5 eV or Al (aluminum) having a work function $\Phi$ of 4.1 eV. A result of the calculation is shown in Table 2.

[Table 2]

|  | Impurity Density (cm$^{-3}$) | Electron Density | Contact Resistance Ratio |
|---|---|---|---|
| Example B | $1 \times 10^{20}$ | $1.1 \times 10^{19}$ | 0.58 |
| Comparative Example B | $1 \times 10^{18}$ | $3.0 \times 10^{18}$ | 1 |

Referring to Table 2, the contact resistance in example C for the semiconductor device of the present invention is reduced by approximately 40% as compared with the contact resistance in comparative example C for the conventional semiconductor device. Thus, according to the semiconductor device of the present invention, the contact resistance can be significantly reduced between the substrate and the electrode (backside electrode). Generally, heat treatment is usually performed after formation of the electrode in order to reduce the contact resistance, but according to the semiconductor device of the present invention, the heat treatment may not be performed.

Although the vertical type MOSFET has been illustrated as one exemplary semiconductor device of the present invention in each of the foregoing embodiments, the semiconductor device of the present invention is not limited to this and may be, for example, a JFET (Junction Field Effect Transistor), a MESFET (Metal Semiconductor Field Effect Transistor), an IGBT (Insulated Gate Bipolar Transistor), a diode or the like.

The embodiments and examples disclosed herein are illustrative and non-restrictive in any respect. The scope of the present invention is defined by the terms of the claims, rather than the embodiments described above, and is intended to include any modifications within the scope and meaning equivalent to the terms of the claims.

INDUSTRIAL APPLICABILITY

A semiconductor device of the present invention is advantageously applicable to a vertical type semiconductor device required to allow for reduced on-resistance.

REFERENCE SIGNS LIST

1: silicon carbide substrate; 2: buffer layer; 3: drift layer; 3A: main surface; 4: well region; 5: $n^+$ region; 6: $p^+$ region; 7: active layer; 10: base layer (base substrate); 10A: main surface; 10B: single-crystal layer; 11: material substrate; 11A: main surface; 20: SiC layer (SiC substrate); 20A, 20B: main surface; 20C: end surface; 40: amorphous SiC layer; 50: ohmic contact layer; 60: carbon layer; 61: precursor layer; 81: first heater; 82: second heater; 91: oxide film (gate oxide film); 92: source contact electrode; 93: gate electrode; 94: interlayer insulating film; 95: source wire; 96: drain electrode; 100: MOSFET.

**Claims**

1. A semiconductor device (100) comprising:

   a silicon carbide substrate (1);
   an active layer (7) made of single-crystal silicon carbide and disposed on one main surface of said silicon carbide substrate (1);
   a first electrode (92) disposed on said active layer (7); and
   a second electrode (96) formed on the other main surface of said silicon carbide substrate (1),
   said silicon carbide substrate (1) including
   a base layer (10) made of silicon carbide, and
   a SiC layer (20) made of single-crystal silicon carbide and disposed on said base layer (10),
   said base layer (10) having an impurity concentration greater than $2 \times 10^{19}$ cm$^{-3}$,
   said SiC layer (20) having an impurity concentration greater than $5 \times 10^{18}$ cm$^{-3}$ and smaller than $2 \times 10^{19}$ cm$^{-3}$.

2. The semiconductor device (100) according to claim 1, wherein said active layer (7) includes:

   a drift layer (3) having a first conductivity type, disposed on/over said silicon carbide substrate (1), and made of single-crystal silicon carbide,
   a well region (4) having a second conductivity type and disposed to include a first main surface (3A) of said drift layer (3) opposite to said silicon carbide substrate (1), and
   a source region (5) having the first conductivity type and disposed in contact with said first electrode (92) to include said first main surface (3A) within said well region (4),
   the semiconductor device (100) further comprising:

      an insulating film (91) disposed on said first main surface (3A) in contact with said well region (4) and made of an insulator; and
      a third electrode (93) disposed on said insulating film (91).

3. The semiconductor device (100) according to claim 2, wherein said insulating film (91) is made of silicon dioxide.

4. The semiconductor device (100) according to claim 2, wherein in said silicon carbide substrate (1), said SiC layer (20) has a main surface (20A) opposite to said base layer (10) and having an off angle of not less than 50° and not more than 65° relative to a {0001} plane.

5. The semiconductor device (100) according to claim 4, wherein the main surface (20A) of said SiC layer (20) opposite to said base layer (10) has an off orientation forming an angle of 5° or smaller relative to a <1-100> direction.

6. The semiconductor device (100) according to claim 5, wherein the main surface (20A) of said SiC layer (20) opposite to said base layer (10) has an off angle of not less than -3° and not more than 5° relative to a {03-38} plane in the <-100> direction.

7. The semiconductor device (100) according to claim 4, wherein the main surface (20A) of said SiC layer (20) opposite to said base layer (10) has an off orientation forming an angle of 5° or smaller relative to a <11-20> direction.

8. The semiconductor device (100) according to claim 1, wherein:

   said silicon carbide substrate (1) further includes an intermediate layer (40, 50, 60) disposed between said base layer (10) and said SiC layer (20) and made of a conductor or a semiconductor, and
   said intermediate layer (40, 50, 60) connects said base layer (10) and said SiC layer (20) to each other.

9. The semiconductor device (100) according to claim 8, wherein said intermediate layer (50) is made of a metal.

10. The semiconductor device (100) according to claim 8, wherein said intermediate layer is made of carbon (60).

11. The semiconductor device (100) according to claim 8, wherein said intermediate layer (40) is made of amorphous silicon carbide.

12. The semiconductor device (100) according to claim 1, wherein:

   said base layer (10) is made of single-crystal silicon carbide, and
   a half width of X-ray rocking curve of said SiC layer (20) is smaller than that of said base layer (10).

13. The semiconductor device (100) according to claim 1, wherein:

   said base layer (10) is made of single-crystal silicon carbide, and
   said SiC layer (20) has a micro pipe density lower than that of said base layer (10).

14. The semiconductor device (100) according to claim 1, wherein:

   said base layer (10) is made of single-crystal silicon carbide, and
   said SiC layer (20) has a dislocation density lower than that of said base layer (10).

15. The semiconductor device (100) according to claim 1, wherein said base layer (10) includes a single-crystal layer (10B made of single-crystal silicon carbide and including its main surface (10A) facing said SiC layer (20).

FIG.1

100

FIG.2

1

FIG.3

```
┌─────────────────────────────┐
│  SILICON CARBIDE SUBSTRATE  │ ── S110
│       PREPARING STEP        │
└─────────────────────────────┘
               │
               ▼
┌─────────────────────────────┐
│    EPITAXIAL GROWTH STEP    │ ── S120
└─────────────────────────────┘
               │
               ▼
┌─────────────────────────────┐
│     ION IMPLANTATION STEP   │ ── S130
└─────────────────────────────┘
               │
               ▼
┌─────────────────────────────┐
│   ACTIVATION ANNEALING STEP │ ── S140
└─────────────────────────────┘
               │
               ▼
┌─────────────────────────────┐
│    OXIDE FILM FORMING STEP  │ ── S150
└─────────────────────────────┘
               │
               ▼
┌─────────────────────────────┐
│    ELECTRODE FORMING STEP   │ ── S160
└─────────────────────────────┘
```

FIG.4

FIG.5

FIG.6

FIG.7

```
┌─────────────────────────────────┐
│   SUBSTRATE PREPARING STEP      │── S10
└─────────────────────────────────┘
              │
              ▼
┌─────────────────────────────────┐
│   SUBSTRATE SMOOTHING STEP      │── S20
└─────────────────────────────────┘
              │
              ▼
┌─────────────────────────────────┐
│         STACKING STEP           │── S30
└─────────────────────────────────┘
              │
              ▼
┌─────────────────────────────────┐
│        CONNECTING STEP          │── S40
└─────────────────────────────────┘
```

FIG.8

```
┌─────────────────────────────────┐
│   SUBSTRATE PREPARING STEP      │── S10
└─────────────────────────────────┘
              │
              ▼
┌─────────────────────────────────┐
│    CLOSELY ARRANGING STEP       │── S50
└─────────────────────────────────┘
              │
              ▼
┌─────────────────────────────────┐
│        SUBLIMATION STEP         │── S60
└─────────────────────────────────┘
```

FIG.9

FIG.10

FIG.11

FIG.12

FIG.13

FIG.14

| SUBSTRATE PREPARING STEP | — S10 |
| Si LAYER FORMING STEP | — S11 |
| STACKING STEP | — S30 |
| HEATING STEP | — S70 |

FIG.15

20
50
10

FIG.16

| SUBSTRATE PREPARING STEP | S10 |

| METAL FILM FORMING STEP | S12 |

| STACKING STEP | S30 |

| HEATING STEP | S70 |

FIG.17

20
60
10

FIG.18

```
┌────────────────────────────────┐
│   SUBSTRATE PREPARING STEP      │─── S10
└────────────────────────────────┘
              │
              ▼
┌────────────────────────────────┐
│   SUBSTRATE SMOOTHING STEP      │─── S20
└────────────────────────────────┘
              │
              ▼
┌────────────────────────────────┐
│  ADHESIVE AGENT APPLYING STEP   │─── S25
└────────────────────────────────┘
              │
              ▼
┌────────────────────────────────┐
│          STACKING STEP          │─── S30
└────────────────────────────────┘
              │
              ▼
┌────────────────────────────────┐
│          PREBAKE STEP           │─── S80
└────────────────────────────────┘
              │
              ▼
┌────────────────────────────────┐
│           FIRING STEP           │─── S90
└────────────────────────────────┘
```

FIG.19

FIG.20

<div align="center">

**INTERNATIONAL SEARCH REPORT**

</div>

| | International application No. |
|---|---|
| | PCT/JP2010/057444 |

A. CLASSIFICATION OF SUBJECT MATTER
*H01L29/12*(2006.01)i, *H01L21/02*(2006.01)i, *H01L21/20*(2006.01)i, *H01L21/336*
(2006.01)i, *H01L29/78*(2006.01)i

According to International Patent Classification (IPC) or to both national classification and IPC

B. FIELDS SEARCHED

Minimum documentation searched (classification system followed by classification symbols)
H01L29/12, H01L21/02, H01L21/20, H01L21/336, H01L29/78

Documentation searched other than minimum documentation to the extent that such documents are included in the fields searched
Jitsuyo Shinan Koho          1922-1996     Jitsuyo Shinan Toroku Koho     1996-2010
Kokai Jitsuyo Shinan Koho     1971-2010     Toroku Jitsuyo Shinan Koho     1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2008-004726 A (Matsushita Electric Industrial Co., Ltd.), 10 January 2008 (10.01.2008), paragraphs [0009], [0064], [0155] to [0176]; fig. 7 (Family: none) | 1-15 |
| Y | WO 2008/120467 A1 (Matsushita Electric Industrial Co., Ltd.), 09 October 2008 (09.10.2008), paragraph [0095] & US 2010/0093161 A     & WO 2008/120467 A1 | 1-15 |
| Y | WO 2006/114999 A1 (Kyoto University), 02 November 2006 (02.11.2006), paragraph [0062] & US 2009/0072243 A1 | 8-11 |

☒   Further documents are listed in the continuation of Box C.          ☐   See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 July, 2010 (26.07.10) | 03 August, 2010 (03.08.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

| | **INTERNATIONAL SEARCH REPORT** | International application No. |
|---|---|---|
| | | PCT/JP2010/057444 |

C (Continuation).   DOCUMENTS CONSIDERED TO BE RELEVANT

| Category* | Citation of document, with indication, where appropriate, of the relevant passages | Relevant to claim No. |
|---|---|---|
| A | WO 01/018872 A1  (Sixon Inc.),<br>15 March 2001 (15.03.2001),<br>page 7, line 1 to page 26, line 24; fig. 1<br>to 11<br>& JP 3854508 B          & EP 1215730 A1<br>& DE 60033829 T          & TW 565630 B | 1-15 |
| A | JP 2002-280531 A  (Denso Corp.),<br>27 September 2002 (27.09.2002),<br>paragraphs [0005] to [0007]; fig. 5, 6<br>(Family: none) | 1-15 |
| A | JP 11-003842 A  (Nippon Pillar Packing Co.,<br>Ltd.),<br>06 January 1999 (06.01.1999),<br>paragraphs [0012] to [0021]; fig. 1 to 4<br>(Family: none) | 1-15 |
| A | JP 11-087200 A  (Toshiba Corp.),<br>30 March 1999 (30.03.1999),<br>paragraphs [0021] to [0023]; fig. 6<br>(Family: none) | 1-15 |
| A | JP 10-223835 A  (Hitachi, Ltd.),<br>21 August 1998 (21.08.1998),<br>paragraphs [0013] to [0068]; fig. 1 to 14<br>(Family: none) | 1-15 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R. C. GLASS et al.** SiC Seeded Crystal Growth. *Phys. stat. sol. (b),* 1997, vol. 202, 149-162